# EUROPEAN PATENT APPLICATION

(11) **EP 4 819 775 A2**
(43) Date of publication of application: **07.10.2026**
(21) Application number: 26167067.3
(22) Date of filing: 24.03.2026
(51) Int. Cl.: H05K 3/3452, H05K 3/00, B23K 26/00, B23K 26/064, B23K 26/067, B23K 26/352, G02B 27/09, G02B 27/14, H05K 3/341

(54) **COMPONENT CARRIER AND A METHOD OF MANUFACTURING A COMPONENT CARRIER**

(30) Priority: 31.03.2025 CN 202510396707
(71) Applicant: AT & S Austria Technologie & Systemtechnik Aktiengesellschaft, 8700 Leoben-Hinterberg (AT)
(72) Inventor: Elaine, Wang, Chongqing, 401120 (CN); Zhang, Zachary, Chongqing, 401133 (CN); Liu, Xinghua, Chongqing, 401133 (CN)
(74) Representative: Dilg, Haeusler, Schindelmann Patentanwaltsgesellschaft mbH

(57) **Abstract**

The present invention describes a component carrier (100) and and a method of manufacturing a component carrier. The component carrier comprises a stack (101) with at least one electrically conductive layer structure (102) and a plurality of electrically insulating layer structures. An outermost electrically insulating layer structure (103) of the plurality of electrically insulating layer structures comprises sections (201, 202) with a plurality of openings (105), said sections (201, 202) corresponding to several planar positions at said outermost electrically insulating layer structure (103). Each opening (105) exposes a conductive portion (106) associated to the least one electrically conductive layer structure (102), wherein each opening (105) has a lateral wall (107) defining the circumference of the respective opening (105). The circumference of each opening (105) has a symmetry axis (108) being perpendicular to a main surface (109) of the electrically conductive layer structure (102).

## Description

### Field of the Invention

. The invention relates to a component carrier comprising sections with several solder resist opening and a method of manufacturing a component carrier.

### Technological Background

. In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

. In particular, very tiny and accurate conductive structures have to be formed in a component carrier for increasing miniaturization. For manufacturing the component carrier, a solder resist layer is applied onto a layer structure of a respective stack. The solder resist layer comprises solder resist openings (SRO) that expose defined sections of the conductive layer structure of a respective stack for further processing. The solder resist layer functions as a mask that leaves only the necessary sections of the layer structure uncovered that have to be treated in a subsequent etching step or in a subsequent controlled solder application step. The solder resist layer is applied onto an outmost layer structure of the stack when the controlled solder application step is going to be processed.

. Due to allowing further miniaturization, more and more solder resist openings have to be formed in a solder resist layer. The solder resist openings may be formed directly or indirectly for example by laser beams. However, laser beams in conventional approaches form solder resist openings having asymmetrical cross sections and nonuniform extensions of the respective opening walls.

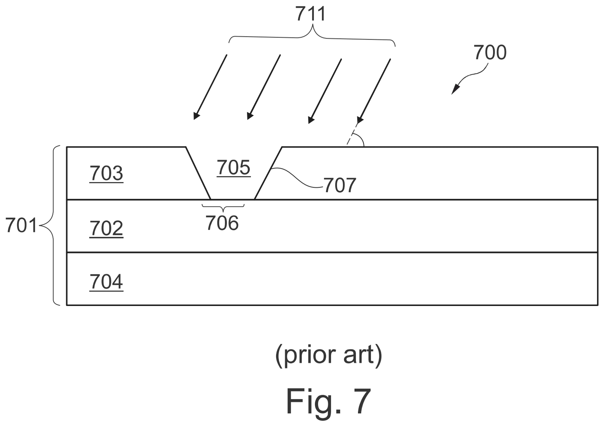

. **Figure 7** shows a conventional component carrier 700 comprising a respective conventional opening 705 in an outermost electrically insulating layer structure 703 of a stack 701 for exposing a conductive portion 706. The stack 701 comprises at least one electrically conductive layer structure 702 and a further electrically insulating layer structures 704. Before forming the conventional openings 705, the surface surrounding the conventional openings 705 is treated with laser beams for solidifying and hardening the outermost electrically insulating layer structure 703 in an area which should remain on the electrically conductive layer structure 702, so that opening regions remain softer and are subsequently removable. As shown in Figure 7, the conventional laser beams 711 have a non-uniform and varying angles different to a perpendicular direction with respect to a main surface of the outermost electrically insulating layer structure 703. Hence, due to the angled conventional laser beams 711, lateral walls 707 and specifically opposing lateral walls 707 have different angles with respect to the main surface of the electrically conductive layer structure 702 which results in unsymmetrical conventional openings 707 of the conventional opening 705.

. Hence, some openings may comprise tapering or irregularly curved sidewalls. The diameter or dimension of one opening may significantly vary along the vertical extension direction of the opening. Besides, there are large differences in size between different openings on the same plane of the outmost layer structure of the stack. It is even difficult to measure the size of these openings due to the asymmetrical and/or nonuniform extensions. Specifically, since the laser beams in conventional approaches might have an inclined angle with respect to a surface of the solder resist layer, the inclination of the sidewalls of respective solder resist openings have an inclined angle as well. Since the laser beams in conventional approaches have an inclined angle, opposing sidewalls of a respective solder resist opening have a different extension and a different inclination, respectively, with respect to each other. Furthermore, in order to provide uniform opening radii of the solder resist openings, complex adjustment of laser beam intensity has to be conducted.

### Summary of the Invention

. There may be a need to provide a component carrier that may be efficiently manufactured with a plurality of highly accurate solder resist openings of a solder resist layer.

. According to an exemplary embodiment of the invention, a component carrier comprises a stack with at least one electrically conductive layer structure and a plurality of electrically insulating layer structures. An outermost electrically insulating layer structure (for example a solder resist layer) of the plurality of electrically insulating layer structures comprises sections with a plurality of openings (solder resist openings (SRO)). The sections correspond to several planar positions at said outermost electrically insulating layer structure. Each opening exposes a conductive portion associated to the least one electrically conductive layer structure, wherein each opening has a lateral wall defining the circumference of the respective opening. The circumference of each opening has a symmetry axis being perpendicular to a main surface of the electrically conductive layer structure. Thus, the symmetry axes of the respective openings are all in particular parallel with respect to each other.

. According to another exemplary embodiment of the invention, a method of manufacturing a component carrier is provided. The method comprises the step of providing a stack comprising at least one electrically conductive layer structure and a plurality of electrically insulating layer structures and a forming in sections of an outermost electrically insulating layer structure of the plurality of electrically insulating layer structures a plurality of openings. The sections correspond to several planar positions at said outermost electrically insulating layer structure. Each opening exposes a conductive portion associated to the least one electrically conductive layer structure, wherein each opening has a lateral wall defining the circumference of the respective opening. The circumference of each opening has a symmetry axis being perpendicular to a main surface of the electrically conductive layer structure.

. The term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an IC (integrated circuit) substrate. In particular, a component carrier may also be embodied as a flexible or semi-rigid substrate. A component carrier may also be a hybrid board combining different ones of the above-mentioned types of component carriers.

. In the context of the present application, the term "stack" may particularly denote an arrangement of multiple planar layer structures which are mounted in parallel on top of one another. For example, the stack may be a laminated stack, i.e. comprising a plurality of layer structures connected by the application of heat and/or pressure.

. In the context of the present application, the term "main surface" of a body (such as the stack or an electrically insulating or conductive layer structure) may particularly denote one of two largest opposing surfaces of the body (such as the stack or a respective electrically insulating or conductive layer structure) and may be connected by the lateral walls of the body. The thickness of a body (such as the stack or a respective insulating or conductive layer structure), may be defined by the vertical distance (along the stack direction, defining the direction along the layers are attached above each other) between the two opposing main surfaces.

. In the context of the present application, the term "layer structure" may particularly denote a continuous layer, a patterned layer or a plurality of non-consecutive islands within a common plane. The layer structures are arranged above each other along a stacking direction (z-direction for forming the stack).

. The electrically insulating layer structure consists of one or a plurality of layers comprise for example resin without fibers or comprising for example fillers, such as fibers, which are woven or which comprises a uniform direction. The electrically insulating layer structures may comprise resin and/or glass fibers, so-called prepreg or FR4 material.

. In the stack, a plurality of electrically conductive layer structure can be provided. As preferred materials, the electrically conductive layer structures are made of copper. The various electrically conductive layer structures may be connected to one another in a desired way by forming holes through the laminated stack, for instance by laser drilling or mechanical drilling, and by partially or fully filling them with electrically conductive material (in particular copper), thereby forming vias or any other through hole connections. The filled hole either connects the whole stack, (through hole connections extending through several layers or the entire stack), or the filled hole connects at least two electrically conductive layers, called via. Similarly, optical interconnections can be formed through individual layers of the stack in order to receive an electro-optical circuit board (EOCB). In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

. The outermost electrically insulating layer structure is directly or indirectly attached to the electrically conductive layer structure and covers the electrically conductive layer structure, wherein the openings expose a conductive portion (e.g., via, trace, pad, pillar, block) of the electrically conductive layer structure. Hence, the exposed conductive portions are reachable from the environment for conducting a respective surface treatment (e.g. surface finish like ENIG (Electroless Nickel Immersion Gold)) or for being filled with respective conductive material (e.g. copper). It allows the exposed conductive portion to remain free so they can be covered with solder material filled in the openings. Alternatively, the through holes can also be filled with insulating material for forming respective protrusions on the exposed conductive portions.

. Hence, the outermost electrically insulating layer structure functions as a solder resist layer that is applied to the main surface of the electrically conductive layer structure in terms of surface treatment. For instance, it is possible to form the outermost electrically insulating layer structure (as solder resist layer) on an entire main surface of the electrically conductive layer structure and to subsequently pattern the layer outermost electrically insulating layer structure for forming the openings so as to expose one or more electrically conductive surface portions which shall be used for being filled with conductive material for electrically coupling the component carrier to an electronic periphery, e.g. a component. The surface portions of the component carrier remaining covered with the outermost electrically insulating layer structure may be efficiently protected against oxidation or corrosion, in particular surface portions containing copper.

. Specifically, the outermost electrically insulating layer structure comprises at least two or more structured sections in which respective openings and hence specific patterns of openings may be formed. The opening characteristics between the openings in the at least two sections may differ with respect to each other. That means, that for example the pattern of the openings and/or the diameters of the openings of one section may differ to the pattern of the openings and/or the diameters of another section of the electrically insulating layer structure.

. The openings may have a circular, elliptical or a polygonal (e.g. square) perimeter (circumference). The openings and its perimeters have a symmetrical profile, so that signal connections with respective connection points of an attachable component is provided. Hence, a symmetry axis of an opening may be defined having a (substantially) perpendicular extension from the surface of the electrically conductive layer structure. The symmetry line extends between the main surfaces of the outermost electrically insulating layer structure. The symmetry axis is in other words the center line of an opening, so that opposing sections of opposing lateral walls of an opening have the same direction to the symmetry line. If the perimeter of an opening is circular or elliptical, the opening profile may be rotationally symmetric and the symmetry line may be an axis of rotation.

. The openings may be formed directly (e.g. by (laser) drilling a hole in the solder resist) or indirectly by laser beam treatment. Indirect laser treatment means that the laser beams solidify and harden the outermost electrically insulating layer structure (e.g. as a solder resist) in an area which should remain on the electrically conductive layer structure (panel), so that the opening regions remains softer and removable. In order to pattern and structurize the solder resist laser by an indirect laser procedure, it is possible to use LDI (Laser Direct Imaging) technique, wherein the laser beams are directly radiated with a high resolution to the surrounding area without needing a mask. The resolution of the laser beams is sufficiently high and accurate so that the edges of the openings can be exactly exposed without exposing the opening areas. Alternatively, it is also possible to use a mask, such as a glass mask, which is applied above the outermost electrically insulating layer structure, wherein the mask covers and shades the opening areas, where the opening should be formed, so that only the areas surrounding the openings are exposed to the laser beams and therefore hardened. In a subsequent surface treatment step (e.g. by developing, i.e. chemical washing) the material at the opening areas of the outermost electrically insulating layer structure can be removed and the respective solder resist openings are thereby created. In a subsequent curing step, the solder resist layer may be finally cured.

. Inn conventional approaches the laser beams are formed e.g. by a punctual laser beam source, so that each laser beam has a different inclination angle on the focal point at the outermost electrically insulating layer structure. Besides, the laser energy received by the outermost electrically insulating layer structure may vary at different planar sections of the outermost electrically insulating layer structure. Hence, the openings comprise asymmetrical cross sections, varying diameters and nonuniform extensions of the respective opening walls. Hence, in conventional approaches, preprocessing and/or post-processing steps has to be conducted in order to achieve the desired opening size with an acceptable quality, for example compensate the opening size at the design stage, meaning to design openings with different sizes on purpose according to the experience of technicians, and/or adjust the process and parameter at the subsequent stage, meaning to change the thickness of the surface finishing layer or the quantity of the soldering material which should be filled in the solder resist opening, and to eventually obtain achieve the desired opening size or soldering performance with an acceptable quality.

. However, according to the present approach, by providing the laser beams having all the (substantially) same inclination angle on the focal point at the outermost electrically insulating layer structure (an inclination angle orthogonal to the outer main surface of the outermost electrically insulating layer structure), the circumference of each opening has a symmetry axis being perpendicular to a main surface of the electrically conductive layer structure, so that the symmetry axes of the openings are in particular all parallel with respect to each other. Hence, the openings of each section of the outermost electrically insulating layer structure may be provided with a symmetry axis being perpendicular to the main surface, with symmetrical cross sections and uniform extensions. Hence, this results also in more accurate adjustment of the desired opening diameters of the openings in each section. Hence, in each defined section of the outermost electrically insulating layer structure the defined openings may be formed within one common laser processing step.

. Furthermore, the openings formed by the direct or indirect laser beam treatment being directed perpendicular to the outer main surface of the outermost electrically insulating layer structures are structurally distinguishable from conventionally formed openings, wherein the conventional laser beams are not precisely directed perpendicular to the outer main surface of the outermost electrically insulating layer structure. Respective openings according to the present invention have a symmetry axis being perpendicular to a main surface of the electrically conductive layer structure. Furthermore, such respective openings according to the present invention can be formed with a straight, uncurved extension of the lateral walls of the openings, wherein the extension of the lateral walls of the openings is perpendicular with respect to the outer main surface of the outermost electrically insulating layer structure.

### Detailed Description of Exemplary Embodiments

. In the following, further exemplary embodiments of the component carrier and the method will be explained.

. According to an exemplary embodiment, the lateral walls of the openings have the same shape and the same extension with respect to each other. Specifically, since the laser beams forming the openings have the same inclination, the opening shape and extensions, for example the opening diameters as well as the shape of the openings, are identical for all openings. For example, if the laser beams form openings with straight cylindrical, curved or conical openings due to the specific intensities of the laser beams, those openings are provided with the same shape. This could provide a good base for the subsequent manufacturing process at the outermost electrically insulating layer structure, for example surface finishing and soldering.

. According to a further exemplary embodiment, the lateral wall of at least one of the openings, in particular of all openings, comprises a homogeneous shape and extension. Hence, since the laser beams forming the openings have the same inclination, in particular perpendicular to the main surface of the electrically conductive layer structure, the walls of the openings may be formed with a homogeneous shape and extension, which means that no artefacts, such as steps, cracks, dimples or protrusions, are formed in the lateral walls of the openings wall. This could improve the adhesion of materials that shall be filled into the at least one opening at the subsequent manufacturing process, for example surface finishing and soldering materials.

. According to a further exemplary embodiment, wherein the lateral walls of at least one opening, in particular all openings, forms a cylindrical shape of the opening. Specifically, by providing the laser beams perpendicular to the main surface of the electrically conductive layer structure and/or by adjusting the laser beam intensity accordingly, the openings may be formed with cylindrical shape. Hence, the opening diameter of the openings at opposing main surfaces of the outermost electrically insulating layer structure are identical, so that cross sections at the covering electrically conductive layer structure on the one side and the opposing side of the outermost electrically insulating layer structure may be identical.

. According to a further exemplary embodiment, the lateral wall of at least one opening, in particular all openings, is substantially perpendicular with respect to the main surface of the electrically conductive layer structure and/or parallel to the symmetry axis of the opening. Hence, by providing the laser beams perpendicular to the main surface of the electrically conductive layer structure, also the lateral walls of the openings are perpendicular. Hence, the lateral walls of each opening may have a straight (non-curved) extension between both opposing main surfaces of the outermost electrically insulating layer structure. Hence, along the symmetry axis of the opening, each opening cross-section has the same circumference. Hence, a constant and predictable flow of thermal and electrical energy can be defined for each opening (benefit for example with electrically conductive end/or family conductive material).

. According to a further exemplary embodiment, the symmetry axis of the at least one opening, in particular of all openings, forming the cylindrical shape has an inclination tolerance with respect to the main surface of the electrically conductive layer structure between 10 to 20 degrees, in particular less than 10 degrees. For example, due to vibrations during forming the openings or due to misalignment of one or more laser beams, the openings may have an inclination tolerance for the symmetry axis is defined above. However, even with those smaller manufacturing tolerances, the openings in the several sections may be formed more homogeneously and constant in comparison to conventional laser beams, wherein a punctual laser source forms the laser beam and each laser beam has a larger different inclination.

. According to a further exemplary embodiment, the lateral wall of at least one of the openings forms a conical shape of the opening, wherein an inner diameter D1 of the opening closest to the main surface of the electrically conductive layer structure is smaller than the opposed outer diameter D2 of the opening at the outermost main surface of the outermost electrically insulating layer structure. Hence, by forming a respective conical opening, the larger radiation section is formed at the outer diameter of the opening at the outermost main surface of the outermost electrically insulating layer structure, such that for example the heat dissipation may be increased for providing a proper heat flow away from the electrically conductive layer structure. According to the present invention and due to the laser beams being directed substantially perpendicular to the main surface of the outermost electrically insulating layer structure, the resulting inclination of the opposed sidewalls within one opening is similar/mirrored and the differences between opposing opening diameters of the opening is small, specifically compared to the conventional approaches, where the inclinations of the lateral walls of the openings are larger and different since the laser beam is coming with a certain flat angle other than orthogonal to the main surface of the outermost electrically insulating layer structure.

. According to a further exemplary embodiment, the inner diameter D1 has the following relation to the outer diameter D2: $- 10 % * D 2 \leq D 2 - D 1 \leq 10 % * D 2 ,$ and $110 % * D 2 \geq D 1 \geq 90 % * D 2$ wherein the lateral side wall of the opening having the conical shape has an inclination angle x with respect to the main surface of the electrically conductive layer structure of $tan x = 2 h / \left(D2-D1\right) .$ wherein h is the high (thickness) of the outermost electrically insulating layer structure.

. Specifically, a respective shape of the conical openings be formed by using the respective straight laser beams having a perpendicular inclination angle with respect of the outer main surface of the outermost electrically insulating layer structure. Furthermore, due to the perpendicular laser, the tapering of the conical opening is quite steep according to the above mentioned formula.

. According to a further exemplary embodiment, the lateral walls of the openings merge with the external main surface of the outermost electrically insulating layer structure by a respective transition portion. The external main surface is defined as the surface being opposed to the main surface facing the electrically conductive layer structure. The transition portion may form a line separating the lateral wall of an opening and the external main surface. However, the transition portion may in particular define a surface area and a smooth transition between the main section of the lateral wall of an opening having a perpendicular symmetry axis with respect to the section of the main surface and the respective external main surface having a planar shape.

. According to a further exemplary embodiment, the transition portions of the plurality of openings have the same shape, the same extension and/or the same dimension one to each other. Specifically, since the laser beams may structure areas of the main surface of the outermost electrically insulating layer structure by illuminating and exposing, the openings have the same inclination, the shape and extensions are identical for all openings.

. According to a further exemplary embodiment the transition portions comprise a rounded edge. The surface area of the transition portion may be less saturated by the laser beam or may receive more attack from chemical reagent and/or physical wear than the main section of the lateral wall of an opening during the manufacturing process. Consequently and as a fingerprint of the invention, the transition portions comprise a rounded edge. Hence, rounded edges are more robust against impacts from outside, in particular since sharp edges that may easily break are prevented.

. According to a further exemplary embodiment, the transition portions have a different shape with respect to the lateral wall of the respective openings. Specifically, due to a respective adjustment of the laser beams forming the openings in the respective sections, the shape of the transition portions of the openings in the one section may differ to the shape of the transition portions of the openings in another section.

. According to a further exemplary embodiment, the transition portions extend through the outermost electrically insulating layer structure of less than one half of the thickness of the outermost electrically insulating layer structure. By the exemplary embodiment it is outlined, that the transition portions of a respective opening do not extend over the center part of a respective lateral wall in a respective opening. Hence, the central part of the lateral wall of an opening may be straight and only the respective transition portions may have for example a rounded edge.

. According to a further exemplary embodiment, the plurality of openings have substantially the same planar extension, in particular same diameters with respect to each other. Specifically, the openings in one and the same section may have the same diameter. However, the openings in at least two or in all sections of the electrically insulating layer structure may have the same diameter, whereas for example the patterns of the respective openings in different sections may vary. This brings the advantage of implementing sections with high density (small diameters of the openings) for signal transmission and sections suitable for power/ground connections (comprising a lower density but larger diameters).

. According to a further exemplary embodiment, the planar extension differences, in particular the diameter differences of the diameters of the openings in one of the sections are less than 0,1%. Specifically, since the laser beams forming the openings have the same inclination, in particular perpendicular to the main surface of the electrically conductive layer structure, the diameters may be formed with a high accuracy and hence a low manufacturing tolerance so that the differences of the diameters of the opening are less than 0,1%. This could provide a good base for the subsequent manufacturing process at the outermost electrically insulating layer structure, for example surface finishing and soldering.

. According to a further exemplary embodiment, the sections comprising the openings extend along the whole outermost electrically insulating layer structure. Hence, the complete outermost electrically insulating layer structure is categorized in at least two sections. In other words, the outermost electrically insulating layer structure does not comprise any regions that are not classified to one of the sections.

. According to a further exemplary embodiment, wherein the sections comprise a section and a further section, each one with a plurality of openings and further openings exposing a conductive portion associated to the least one electrically conductive layer structure. In an exemplary embodiment, the openings and the further openings have different dimensions, in particular different diameters, with respect to each other. Hence, the electrically conductive layer structure may be covered with the outermost electrically insulating layer structure, wherein the outermost electrically insulating layer structure comprise at least two, in particular a plurality of sections, that are defined in a specific pattern along the main surface of the outermost electrically insulating layer structure. Each section comprises a respective group of openings. The openings of one section may have different dimensions and/or distributions than the further openings of another section. The sections may be arranged adjacent to each other. Furthermore, the sections may be arranged spaced apart from each other. For example, between a section and a further section, a surface section of the electrically insulating layer structure may be arranged. Hence, by the different sections having openings with different dimensions and/or distributions, plurality of different exposed conductive portions under the electrically conductive layer structure may be provided for different applications. For example, in the first section having a plurality of openings with small diameters and high densities, a high complex component having a plurality of signal connecting points with the component carrier may be arranged. In another section, having only a few openings but with large diameter and low density, components can be connected and/or coupled to the component carrier that have a need for higher thermal transfer or for high currents.

. According to a further exemplary embodiment, the thickness of the outermost electrically insulating layer structure in the section differs to the thickness of the outermost electrically insulating layer structure in the further section. Hence, since the laser beams may have a perpendicular inclination with respect to the outer surface of the outermost electrically insulating layer structure, the thickness of the outermost electrically insulating layer structure does not affect the penetration angle of the laser beam. Hence, the thickness of the outermost electrically insulating layer structure may vary and the openings may all have the same opening shapes and dimensions in the thinner regions as well as in the thicker regions of the outermost electrically insulating layer structure. In contrast to this, if laser beams build have an inclination angle other than 90° with respect to the outer surface of the outermost electrically insulating layer structure, the shape of the openings in the thicker regions would differ to the shape of the openings in the regions of the thinner section of the outermost electrically insulating layer structure.

. According to a further exemplary embodiment, the shape and the extension of the lateral walls of the respective openings and the further openings are the same. Hence, due to the laser beams having a perpendicular inclination with respect to the outer surface of the outermost electrically insulating layer structure, shape and the extension of the lateral walls of the openings in the different sections may be the same.

. According to a further exemplary embodiment, the dimensions, in particular the diameter, the direction of the symmetry axis and/or the extension and the shape of the lateral walls, of the openings and the further openings differ between each other of less than 0,1%. Specifically, since the laser beams forming the openings have the same inclination, in particular perpendicular to the main surface of the electrically conductive layer structure, the dimensions of the openings may be formed with a high accuracy and hence a low manufacturing tolerance so that the differences of the diameters of the opening are less than 0,1%.

. According to a further exemplary embodiment, each of the openings in the section have a first volume and each of the further openings in the further section have a second volume, wherein the volumes of the openings in the section and the further volumes of the further openings in the further section differ between each other of less than 1%, in particular the volumes of the openings and the volumes of the further openings are equal to each other. This brings the advantage that the same amount of filling medium (such as solder material-balls) can be placed in the openings in a further production step resulting in a high reliable connection with the later assembled component. As described above, since the laser beams forming the openings have the same inclination, in particular perpendicular to the main surface of the electrically conductive layer structure, the volumes of the openings may be formed with a high accuracy and hence a low manufacturing tolerance so that the differences of the diameters of the opening are less than 0,1%.

. According to a further exemplary embodiment, each of the openings of at least one of the sections is filled by an electrically conductive connection material for forming in particular an electrically conductive protrusion, in particular a solder material-ball. The electrically conductive connection material may be in particular copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively. Specifically, by providing the electrically conductive protrusion, in particular the solder material-ball, respective connections to components fixed onto the surface of the outer electrically insulating layer structure can be provided.

. According to a further exemplary embodiment, the volumes of the electrically conductive connection materials protruding out of the respective openings (in one of the sections or in other sections) are equal to each other. Specifically, since the openings are formed precisely due to be laser beam having a perpendicular inclination with respect to the outer main surface of the outermost electrically insulating layer structure, the shape and the volumes of the openings can be formed equally so that also the filling volume and the protrusion of the solder material can be formed very precisely.

. According to a further exemplary embodiment, each of the further openings of the further section is filled by a further electrically conductive connection material for forming in particular an electrically conductive protrusion, in particular a solder material-ball. In particular, the volumes of the electrically conductive connection materials protruding out of the respective openings of the section and the further volumes of the further electrically conductive connection materials protruding out of the respective further openings of the further section differ with respect to each other. Hence, in one section of the protruding section of the solder material is higher and comprises more material in comparison to another section. Hence, the respective protruding solder material can be exactly adjusted respect to the respective coupling component.

. According to a further exemplary embodiment, each the outermost electrically insulating layer structure is a solder resist layer, wherein the solder resist layer is in particular a solder resist ink or a dry film layer. The outermost electrically insulating layer structure functioning as a solder resist layer may be a flat layer structure covering only part or the complete area of the main surfaces the electrically conductive layer structure. Solder resist material may protect the stack or part thereof against oxidation or corrosion, in particular may protect surface portions containing a metal such as copper. Furthermore, solder resist layer covers one or more surface portions of the electrically conductive layer structure of the component carrier on which no solder material shall and will attach. To put it shortly, the material of the solder resist layer may be selected so that solder material will not attach or remain on surface regions of a stack of a component carrier which are covered by the solder resist. The solder resist layer, which may also be denoted as solder mask, may be a thin lacquer-like layer, for instance of polymer, that may be applied to the electrically conductive layer structure comprising for example surface metal (in particular copper traces of a component carrier, such as a printed circuit board (PCB)) for protection against oxidation and to prevent solder bridges from forming between closely spaced solder pads. In this context, a solder bridge may be an unintended electrical connection between two electrically conductive structures by a spot of solder. A solder resist layer may prevent solder bridges. Once applied as a continuous layer on the conductive layer structure of the stack, the openings in the respective sections can be created in the solder resist layer where material shall be electrically connected with the electrically conductive layer structures of the stack, for instance for connecting them electrically with one or more surface mounted components to be soldered on the stack. Such openings may be formed by patterning the continuous layer of solder resist layer on the stack, for example using the above-described laser beams.

. In an embodiment, a material of the outermost electrically insulating layer structure functioning as a solder resist is a wet ink or a dry film and may comprise organic material, e.g. resin and/or provide the function of a colorant.

. According to a further exemplary embodiment, the outermost electrically insulating layer structure is an organic material. For example, the outermost electrically insulating layer structure is made of resin with or without reinforcing elements like (glass) spheres or fibers. Hence, the outermost electrically insulating layer structure may be not fully cured, in particular uncured or only partially cured, and is therefore still moldable.

. According to a further exemplary embodiment, the plurality of openings are configured for being electrically connected to a component or to a plurality of components for forming a component assembly.

. The one or more components may be surface mounted on the stack, in particular to the outer surface of the outermost electrically insulating layer structure. Alternatively, at least one opening and preferably at least one component is located in a cavity of the stack with the advantage to reduce the overall height of the package. In the context of the present application, the term "component" may particularly denote any bulky rather than layer-type block. The component may be an electronic component, such as an active (for example a semiconductor chip or semiconductor package) or passive (for instance a capacitor or an inductor) electronic component embedded or to be embedded within an interior of the component carrier. However, the component may also be a non-electronic component without electronic functionality. For example, the component may be a component with thermal functionality, such as a heat removal and/or heat spreading functionality. For example, the component may be a metal (for instance copper) block and/or ceramic block.

. According to a further exemplary embodiment of the method, the step of forming the plurality of openings comprises a radiating at least one laser beam to a surrounding area surrounding an opening area, so that the surrounding area is hardened, and removing material of the outermost electrically insulating layer structure, in particular by a wet chemical process (chemical washing, developing), at the opening area for forming the openings.

. According to a further exemplary embodiment of the method, the step of providing at least one laser beam comprises a scattering of the laser beam through a scattering device. The scattering device is configured so that the laser beam is split to provide a plurality of scattered laser beams, wherein each scattered laser beam is formed by being reflected at a point of incidence on a reflecting portion (e.g. on a respective mirror) of the scattering device. The points of incidence being provided in the scattering device at different reflecting positions (e.g. at different mirrors) with respect to the focal points on the outermost electrically insulating layer structure. The scattered laser beams penetrate the different focal points on the outermost electrically insulating layer structure of the stack (e.g. the opening area or the surrounding area), so that the scattered laser beams (directly or indirectly) harden the surrounding area surrounding the plurality of openings and so that the circumference of each opening has a symmetry axis being perpendicular to a main surface of the electrically conductive layer structure.

. A scattering device for generating a plurality of scattered laser beams is a device that takes an incoming laser beam and splits or scatters it into multiple laser beams in different directions. The scattered laser beams are further directed by a reflecting position in the scattering device. The reflecting position may be in particular a respective mirror that directs an incoming laser beam at a point of incidence at the mirror to a desired output direction. The output laser beam is directed in such a way, that a desired focal point on the outer surface, in particular the surrounding area, of the outermost electrically insulating layer structures is hit in order to harden the surrounding area surrounding the plurality of openings, so that the outermost electrically insulating layer structure is structured. Specifically, the output direction is adjusted by the reflecting portion such that the output laser beam is perpendicular to the surface of the outermost electrically insulating layer structure.

. According to a further exemplary embodiment, the point of incidence and the focal point define an inclination angle of the laser beam generated by the scattering device in a range between 89,5 to 90,5 degree, in particular 90 degree, to the outer main surface of the outermost electrically insulating layer structure. Hence, each scattered laser beam may penetrate a surrounding areas surrounding an opening area, so that the surrounding areas are hardened and the opening areas are not hardened. Hence in a subsequent step the material of the opening areas can be removed. The openings in the opening areas have a symmetry axis perpendicular to the main surface of the outermost electrically insulating layer structure.

. According to a further exemplary embodiment, the scattering device comprises a plurality of mirrors (each defining a reflecting portion) for generating the scattered laser beams, wherein each scattered laser beam is reflected at one of the points of incidence on said mirrors.

. According to a further exemplary embodiment, the scattering device is configured to adjust the points of incidence to different positions (and e.g. orientations) with respect to the planar extension of the outermost electrically insulating layer structure, in particular by moving and adjusting the mirrors. The mirrors may be controlled with respective activators that are configured for adjusting the orientation of the respective mirror and/or to move the mirror along the scattering device. Hence, the orientation of the mirror and/or the position of the mirror with respect to the focal point on the external surface of the outermost electrically insulating layer structure is adjustable, so that the laser beam energy received in the respective sections can be adjusted.

. According to a further exemplary embodiment, the scattering device generates 100 to 250 scattered laser beams per mm2 (square millimeters) so that a respective number of points of incidence above the outermost electrically insulating layer structure is generated. Thus, a very precise and structured pattern of surrounding areas and opening areas can be exposed to the laser beams, so that, e.g. after a development by a chemical washing step, a high number of openings with very precise dimensions can be formed. Accordingly, in an exemplary embodiment, the scattering device may comprise for example 100 to 250 mirrors in order to generate the respective number of points of incidence and focal point, respectively. This may largely increase the manufacturing flexibility for a high density of very precise openings formed in a respective desired pattern in the outermost electrically insulating layer structure.

. In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

. In an embodiment, the component carrier is configured as one of the group consisting of a printed circuit board, a substrate (in particular an IC substrate), and an interposer.

. In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through hole connections. The filled hole either connects the whole stack, (through hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

. In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

. The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

. In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures (i.e. fillers) such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

. In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

. At least one component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

. In an embodiment, the component carrier obtained from the component carrier structure is a laminate-type component carrier. In such an embodiment, the component carrier is a compound of multiple layer structures which are stacked and connected together by applying a pressing force and/or heat.

. After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

. After having completed formation of a stack of electrically insulating layer structures and electrically conductive layer structures, it is possible to proceed with a surface treatment of the obtained layers structures or component carrier.

. It is also possible to apply a surface finish selectively to exposed electrically conductive surface portions of the component carrier in particular the openings in terms of surface treatment. Such a surface finish may be an electrically conductive cover material on exposed electrically conductive layer structures (such as pads defining the bottom of the openings, conductive traces, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

. The aspects defined above and further aspects of the invention are apparent from the examples of embodiment to be described hereinafter and are explained with reference to these examples of embodiment.

### BRIEF DESCRIPTION OF THE DRAWINGS

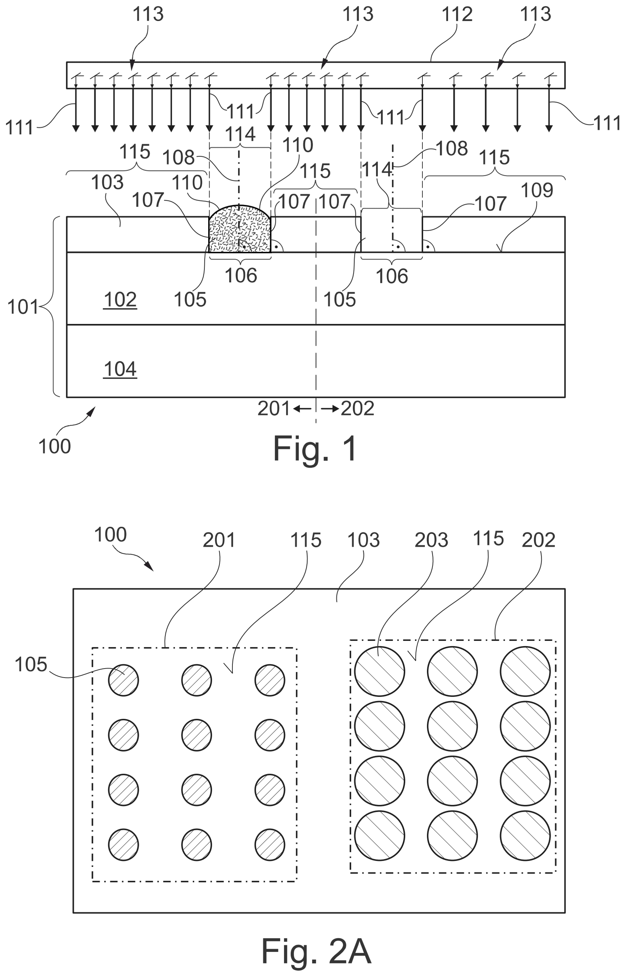

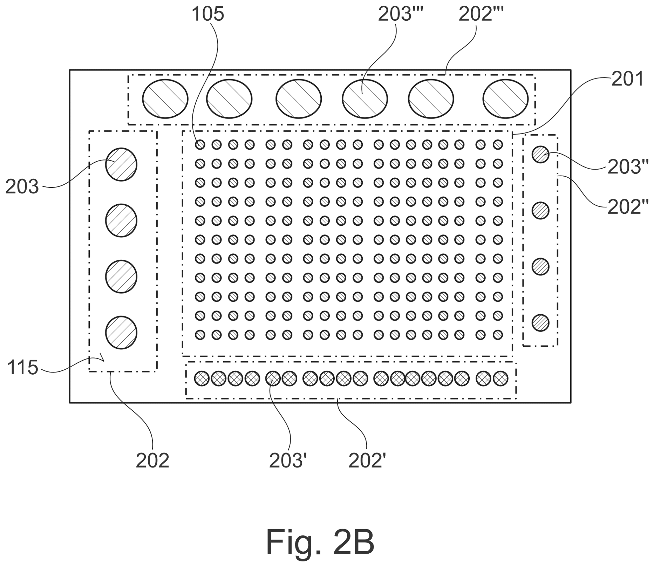

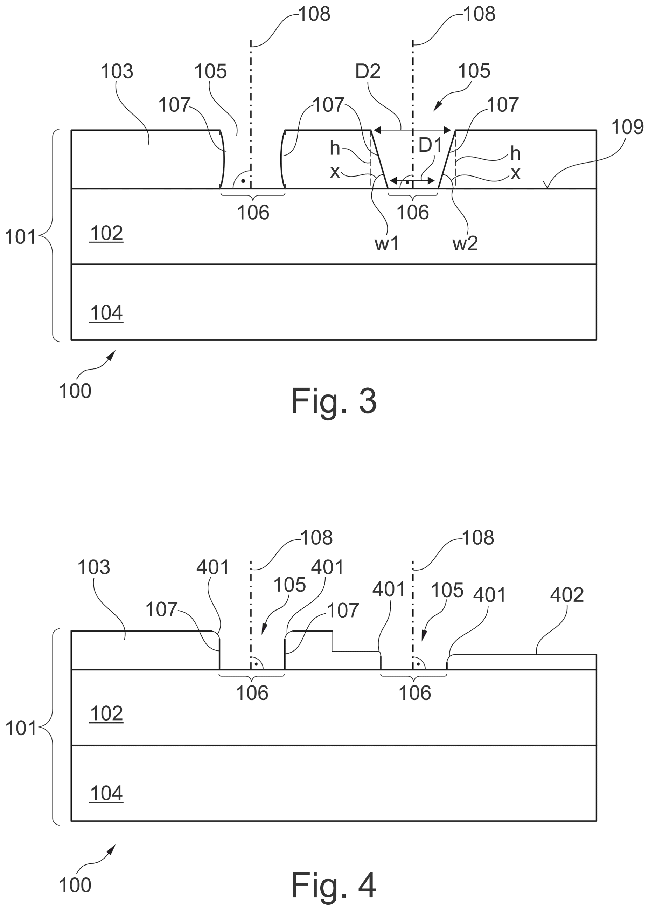

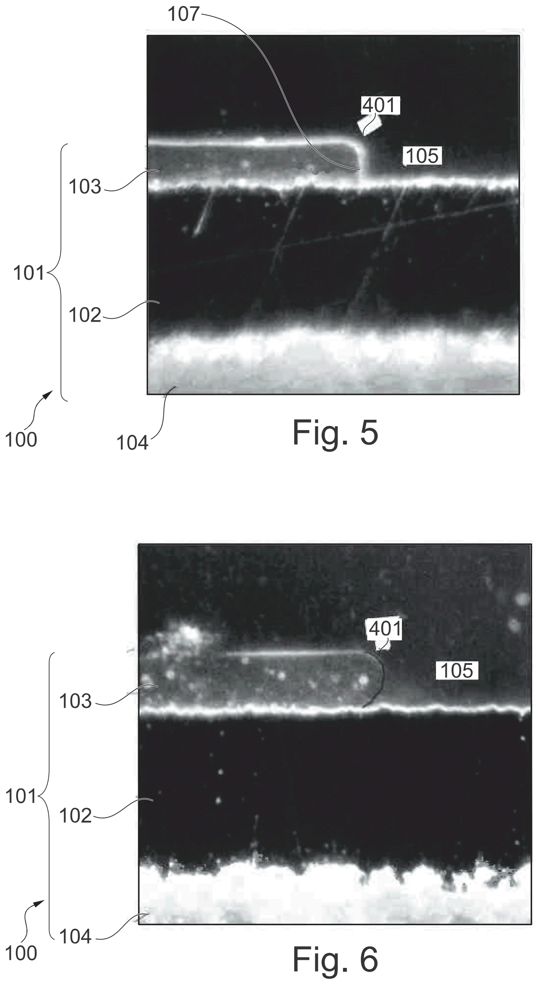

. Figure 1 illustrates a schematic view of a component carrier comprising respective openings in an outermost electrically insulating layer structure according to an exemplary embodiment of the invention.
. Figure 2A illustrates a schematic image of an outermost electrically insulating layer structure comprising two opening sections according to an exemplary embodiment of the invention.
. Figure 2B illustrates a schematic image of an outermost electrically insulating layer structure comprising a plurality of opening sections according to an exemplary embodiment of the invention.
. Figure 3 illustrates a schematic view of a component carrier comprising respective openings with a curved and conical shape according to an exemplary embodiment of the invention.
. Figure 4 illustrates a schematic view of a component carrier comprising respective openings with a straight extension and a transition portion in an outermost electrically insulating layer structure according to an exemplary embodiment of the invention.
. Figure 5 illustrates an image of a component carrier having an opening with a straight extension and a transition portion according to an exemplary embodiment of the invention.
. Figure 6 illustrates an image of a component carrier having an opening with a curved extension according to an exemplary embodiment of the invention.
. Figure 7 illustrates a schematic view of a conventional component carrier comprising a conically shaped opening.

. The illustrations in the drawings are schematic. In different drawings, similar or identical elements are provided with the same reference signs.

### DETAILED DESCRIPTION

. Figure 1 shows a component carrier 100 comprising respective openings 105 in an outermost electrically insulating layer structure 103 according to an exemplary embodiment of the invention. The component carrier 100 comprises a stack 101 with at least one electrically conductive layer structure 102 and a plurality of electrically insulating layer structures 103, 104. An outermost electrically insulating layer structure 103 of the plurality of electrically insulating layer structures 103, 104 comprises sections 201, 202 (see Figure 2A, Figure 2B) with a plurality of openings 105, said sections 201, 202 corresponding to several planar positions at said outermost electrically insulating layer structure 103. Each opening 105 exposes a conductive portion 106 (e.g., via, trace, pad, pillar, block) associated to the least one electrically conductive layer structure 102, wherein each opening 105 has a lateral wall 107 defining the circumference of the respective opening 105. The circumference of each opening 105 has a symmetry axis 108 being perpendicular to a main surface 109 of the electrically conductive layer structure 102.

. The outermost electrically insulating layer structure 103 is in the shown embodiment directly attached to the electrically conductive layer structure 102 and covers the electrically conductive layer structure 102, wherein the openings 105 expose the conductive portions 106 of the outermost electrically insulating layer structure 103. Hence, the exposed conductive portions 106 are reachable from the environment for conducting a respective surface treatment or for being filled with respective conductive material connection material 110 e.g. copper.

. The outermost electrically insulating layer structure 103 functions as a solder resist layer that is applied to the main surface 109 of the electrically conductive layer structure 102 in terms of surface treatment. For instance, it is possible to form the outermost electrically insulating layer structure 103 as solder resist layer on an entire main surface of the electrically conductive layer structure 102 and to subsequently pattern the layer outermost electrically insulating layer structure 103 for forming the openings 105 so as to expose one or more electrically conductive surface portions which shall be used for being filled with conductive connection material 110 for electrically coupling the component carrier 100 to an electronic periphery, e.g. a component. The solder resist layer is in particular a solder resist ink or a dry film layer. The surface portions of the component carrier 100 remaining covered with the outermost electrically insulating layer structure 103 may be efficiently protected against oxidation or corrosion, in particular surface portions containing copper.

. The openings 105 may be formed directly or indirectly by laser beam treatment. The laser beams 111 have all the same inclination angle on the focal point at the outermost electrically insulating layer structure 103. The inclination angle is orthogonal to the outer main surface of the outermost electrically insulating layer structure 103. In Figure 1, the openings 105 are formed indirectly by the laser beams 111. The laser beams 111 penetrate and expose a surrounding area 115 surrounding an opening area 114, so that the surrounding areas 115 are hardened and the opening areas not. The surrounding area 115 define areas that remain on the electrically conductive layer structure 102, so that the opening regions 114 remains softer and removable. In order to pattern and structurize the outermost electrically insulating layer structure 103 by an indirect laser procedure, LDI (Laser Direct Imaging) technique may be used, wherein the laser beams 111 are directly radiated with a high resolution to the surrounding area 115 without needing a mask. The resolution of the laser beams 111 is sufficiently high and accurate so that the edges of the openings 105 can be exactly exposed without exposing the opening areas 114. Alternatively a mask, such as a glass mask, is applied above the outermost electrically insulating layer structure 103, wherein the mask covers and shades the opening areas 114, where the opening 105 should be formed, so that only the surrounding areas 115 surrounding the openings 105 are exposed to the laser beams 1111 and therefore hardened. In a subsequent surface treatment step (e.g. by chemical washing) the material of the outermost electrically insulating layer structure 103 is removed and the respective solder resist openings 105 are thereby created. In a subsequent curing step, the outermost electrically insulating layer structure 103 may be finally cured.

. Therefore, a circumference of each opening 105 has a symmetry axis 108 being perpendicular to a main surface 109 of the electrically conductive layer structure 102. Hence, the openings 105 of each section 201 of the outermost electrically insulating layer structure 103 are provided with a symmetry axis 108 being perpendicular to the main surface 109, with symmetrical cross sections and uniform extensions.

. The scattering device 112 is configured so that an initial laser beam is split to provide a plurality of scattered laser beams 111, wherein each scattered laser beam 111 is formed by being reflected at a point of incidence on a reflecting portion e.g. on a respective mirror 113 of the scattering device 112. The points of incidence being provided in the scattering device 112 at different reflecting positions, e.g. at different mirrors 113, being arranged with respect to the focal points on the outermost electrically insulating layer structure 103. The scattered laser beams 111 penetrate the different focal points on the outermost electrically insulating layer structure 103 of the stack 101, so that the scattered laser beams 111 directly or indirectly form the plurality of openings 105 and so that the circumference of each opening 105 has a symmetry axis 108 being perpendicular to a main surface 109 of the electrically conductive layer structure 102. The respective mirror 113 directs an incoming laser beam at a point of incidence at the mirror 113 to a desired output direction. The output laser beam 111 is directed in such a way, that a desired focal point on the outer surface of the outermost electrically insulating layer structures 103 is hit in order to structure the electrically insulating layer structure 103. Specifically, the output direction is adjusted by the reflecting portion such that the output laser beam is perpendicular to the surface of the outermost electrically insulating layer structure 103.

. The scattering device 112 comprises a plurality of mirrors 113 each defining a reflecting portion (points of incidence) for generating the scattered laser beams 111. The scattering device 112 is configured to adjust the points of incidence to different positions and e.g. orientations with respect to the planar extension of the outermost electrically insulating layer structure 103, in particular by moving and adjusting the mirrors 113. The mirrors 113 controlled by respective activators that are configured for adjusting the orientation of the respective mirror 113 and/or to move the mirror 113 along the scattering device 112. Hence, the orientation of the mirror 113 and/or the position of the mirror 113 with respect to the focal point on the external surface of the outermost electrically insulating layer structure 103 is adjustable, so that the laser beam energy received at the surrounding area 115 can be adjusted. The scattering device 112 may generate 100 to 250 scattered laser beams per mm2 and may therefore comprise e.g. 100 to 250 mirrors.

. The lateral walls 107 of the openings 105 in one section 201 may have the same shape and the same extension with respect to each other. Specifically, since the laser beams forming the openings 105 have the same inclination, the opening shape and extensions, for example the opening diameters as well as the shape of the openings 105, are identical for all openings 105.

. The lateral wall 107 of the openings 105 in a section 201 comprises a homogeneous shape and extension. Hence, since the laser beams 111 penetrating the surrounding area 115 have the same inclination, in particular perpendicular to the main surface 109 of the electrically conductive layer structure 102, the lateral walls 107 of the openings 105 may be formed with a homogeneous shape and extension, which means that no artefacts, such as steps, cracks, dimples or protrusions, are formed in the wall openings. Specifically, the opposed lateral walls 107 in one opening 105 (specifically if the opening 105 has a rectangular cross section) may have the same shape.

. For example, the lateral walls 107 of the openings 105 in a section 201 forms a cylindrical shape of the opening 105. Specifically, by providing the laser beams 111 perpendicular to the main surface 109 of the electrically conductive layer structure 102 and/or by adjusting the laser beam intensity accordingly and/or by providing a very accurate mask (glass mask), the hardening at interface regions between the surrounding areas 115 and the opening areas 114 may be very accurate, so that, e.g. after a washing step (development), the openings 105 may be formed precisely with a cylindrical shape. Hence, the opening diameter of the openings 105 at opposing main surfaces 109 of the outermost electrically insulating layer structure 103 are identical, so cross sections at the covering electrically conductive layer structure 102 on the one side and the opposing side of the outermost electrically insulating layer structure 103 are identical.

. Specifically, the lateral walls 107 of the openings 105 are substantially perpendicular with respect to the main surface 109 of the electrically conductive layer structure 102 and/or parallel to the symmetry axis 108 of the opening 105. Hence, by providing the laser beams perpendicular to the main surface 109 of the electrically conductive layer structure 102, also the lateral walls 107 of the openings 105 are perpendicular. Hence, the lateral walls 107 of each opening 105 may have a straight non curved extension between both opposing main surfaces 109 of the outermost electrically insulating layer structure 103. Hence, along the symmetry axis 108 of the openings 105, each opening cross-section has the same circumference.

. Each of the openings 105 of at least one of the sections 201, 202 is filled by an electrically conductive connection material 110 for forming in particular an electrically conductive protrusion, in particular a solder material-ball. The electrically conductive connection material 110 may be in particular copper. The volumes of the electrically conductive connection materials 110 protruding out of the respective openings 105 in one of the sections 201 also in other sections 202 are equal to each other or differ between the sections 201, 202. Specifically, since the laser beams 111 penetrate and expose the surrounding area 115 very precisely, a practice pattern of opening areas 114 and surrounding areas 115 can be formed due to the laser beam 111 having a perpendicular inclination with respect to the outer main surface of the outermost electrically insulating layer structure 103. Hence, the shape and the volumes of the openings 105 can be formed equally so that also the filling volume and the protrusion of the solder material can be formed precisely.

. The outermost electrically insulating layer structure 103 comprises organic material, e.g. resin and may be applied as a wet ink or as a dry film layer on the stack. Alternatively, the outermost electrically insulating layer structure 103 comprises mold material.

. Figure 2A illustrates a schematic image of an outermost electrically insulating layer structure 103 comprising two opening sections 201, 202 according to an exemplary embodiment of the invention.

. The illustrated outermost electrically insulating layer structure 103 comprises two sections 201, 202. Openings 105 are formed in a certain pattern in section 201 and further openings 203 are formed in a predefined pattern in the further section 202. The opening characteristics of the openings 105, 203 between at least two sections 201 differ. In the exemplary embodiment shown in Figure 2A, the openings 105 in the section 201 are smaller with respect to the openings 203 formed in the further section 202. The distribution of the openings 105 in the section 201 may also be different with respect to the openings 203 formed in the further section 202 (not shown).

. The outermost electrically insulating layer structure 103 covers completely the electrically conductive layer structure 102 (apart from the openings). The outermost electrically insulating layer structure 103 is categorized in the two sections 201, 202. The openings 105 and the further openings 203 have different dimensions. The sections 201, 202 are arranged spaced apart from each other, so that between a section 201 and a further section 202, a surface section of the electrically insulating layer structure without openings is provided. Hence, by the different sections 201, 202 having openings 105 with different dimensions, plurality of different exposed conductive portions 106 under the electrically conductive layer structure 102 may be provided for different applications. For example, in the first section 201 having a plurality of openings 105 with small diameters and high densities, a high complex component having a plurality of signal connecting points with the component carrier 100 may be arranged. In another section 202, having only a few openings 203 but with large diameter and low density, components can be connected and/or coupled to the component carrier 100 that have a need for higher thermal transfer or for high currents.

. The openings 105 in the section 201 have a first volume and each of the further openings 203 in the further section 202 have a second volume, wherein the volumes of the openings 105 in the section 201 and the further volumes of the further openings 203 in the further section differ between each other. Since the laser beams 111 forming the openings 105, 203 have the same inclination, in particular perpendicular to the main surface 109 of the electrically conductive layer structure 102, the volumes of the openings 105, 203 may be formed with a high accuracy and hence a low manufacturing tolerance. Hence, shape and the extension of the lateral walls 107 as shown in Figure 1 of the respective openings 105 and the further openings 203 may be the same although the diameters may differ between each other. In a further embodiment, the first volume and the second volume may be the same.

. Each of the further openings 203 of the further section 202 is filled by a further electrically conductive connection material 110 for forming in particular an electrically conductive protrusion, in particular a solder material-ball. In particular, the volumes of the electrically conductive connection materials 110 protruding out of the respective openings 105 of the section 201 and the further volumes of the further electrically conductive connection materials 110 protruding out of the respective further openings 203 of the further section 202 differ with respect to each other. In a further embodiment, the volumes of the electrically conductive connection materials 110 protruding out of the respective openings 105 of the section 201 and the further volumes of the further electrically conductive connection materials 110 protruding out of the respective further openings 203 of the further section 202 may be the same.

. Figure 2B illustrates a schematic image of an outermost electrically insulating layer structure 103 comprising a plurality of opening sections 201, 202 according to an exemplary embodiment of the invention.

. The shown specific embodiment, a central section 201 comprising a large number of openings 105 with smaller diameters are formed. In the environment of the center section 201, a plurality of further sections 202, 202', 202", 202‴ are formed, wherein each further sections 202, 202', 202", 202‴ comprises respective openings 203, 203', 203", 203‴. In each of the sections 201, 202, 202', 202", 202"', the diameters of the respective openings 105, 203, 203', 203", 203‴ are identical. However, the respective openings 105, 203, 203', 203", 203‴ may have different diameters and distributions with respect to each other. The shown example, the center section 201 comprises the openings with smaller diameters, while the respective surrounding openings 203, 203', 203", 203‴ of the further sections 202, 202', 202", 202‴ have much larger opening diameters. Due to the laser beams 111 having a perpendicular extension with respect to the main surface of the outermost electrically insulating layer structure 103, the respective openings 105, 203, 203', 203", 203‴ may have a symmetry (center) axis 108 perpendicular to the main surface 109 of the electrically conductive layer structure 102 and may also have straight lateral walls 107.

. Figure 3 illustrates a schematic view of a component carrier 100 comprising respective openings 105 with a curved and a conical shape according to an exemplary embodiment of the invention. One lateral wall 107 of the shown openings 105 forms in an example a slight conical shape, wherein an inner diameter D1 of the opening closest to the main surface 109 of the electrically conductive layer structure 102 is smaller than the opposed outer diameter D2 of the opening 105 at the outermost main surface of the outermost electrically insulating layer structure 103. Specifically, a respective shape of the conical openings 105 may be formed due to laser beam tolerances of the respective straight laser beams 111 having an inclination angle range of 89.5 to 90.5 with respect of the outer main surface of the outermost electrically insulating layer structure 103. Hence, by the using the scattered laser beams 111, the range of the inclination angle is very small, so that only small differences w1, w2 between the diameters D1 and D2 exist and the degree of inclination x of both lateral walls 107 are almost similar. Therefore, the conical shape at the one hand side is minimized on the other hand almost symmetric (mirrored) lateral walls 107 are formed.

. Furthermore, for example by tuning the intensity of the laser beams 111, a curved sidewall 107 shown in on the left side in the exemplary embodiment in Figure 3 may be generated. Thus, the bottom surface of the opening is increased which leads to a better mechanical connection of the filling medium 110 to the electrically conductive layer structure 102.

. Figure 4 illustrates a schematic view of a component carrier 100 comprising respective openings 105 with a straight extension and a transition portion 401 in an outermost electrically insulating layer structure 103 according to an exemplary embodiment of the invention.

. The lateral walls 107 of the openings 105 merge with the external main surface 402 of the outermost electrically insulating layer structure 103 by a respective transition portion 401. The external main surface 402 is defined as the surface being opposed to the main surface 109 facing the electrically conductive layer structure 102. The transition portion 401 forms a portion separating the lateral wall 107 of an opening 105 and the external main surface 402. Hence, the transition portion 401 may in particular define a surface area and a smooth transition between the straight main section of the lateral wall 107 of an opening 105 being parallel to the perpendicular symmetry axis 108 and the respective external main surface 402 having a planar shape. The transition portions 401 of the plurality of openings 105 have the same shape, the same extension and/or the same dimension one to each other. Specifically, since the laser beams forming the surrounding areas 115 of the openings 105 have the same inclination, the shape and extensions are identical for all openings 105 and specifically of its transition portions 401. Specifically, the transition portions 401 comprise rounded edges.

. However, due to a respective adjustment of the laser beams 111 forming the openings 105, 203 in the respective sections 201, 202, the shape of the transition portions 401 of the openings 105 in the one section 201 may differ to the shape of the transition portions 401 of the openings 203 in another section 202.

. The transition portions 401 extend through the outermost electrically insulating layer structure 103 of less than one half of the thickness of the outermost electrically insulating layer structure 103. The transition portions 401 of a respective opening 105 do not extend over the center part of a respective lateral wall 107 in a respective opening 105. Hence, the central part of the lateral wall 107 of an opening 105 may be straight and only the respective transition portions 401 may have for example a rounded edge.

. Furthermore, the thickness of the outermost electrically insulating layer structure 103 in a section 201 differs to the thickness of the outermost electrically insulating layer structure 103 in a further section 202. Hence, since the laser beams 111 may have a perpendicular inclination with respect to the external main surface 402 of the outermost electrically insulating layer structure 103, the thickness of the outermost electrically insulating layer structure 103 does not affect the penetration angle of the laser beam 111. Hence, between the thickness of the outermost electrically insulating layer structure 103 may vary and the openings 105 may all have the same opening shapes and dimensions in the thinner regions as well as in the thicker regions of the outermost electrically insulating layer structure 103.

. Figure 5 illustrates an image of a component carrier 100 having in the outermost electrically insulating layer structure 103 an opening 105 with a lateral wall 107 having a straight extension similar to the schematically shown openings 105 in Figure 4. The lateral walls 107 of the opening 105 merge with the external main surface 402 of the outermost electrically insulating layer structure 103 by a respective transition portion 401. The transition portion 401 forms a portion separating the lateral wall 107 of an opening 105 and the external main surface 402. The transition portion 401 is formed with a round edge.

. Figure 6 illustrates an image of a component carrier 100 having in the outermost electrically insulating layer structure 103 an opening 105 with a lateral wall 107 having a curved extension similar to the schematically shown openings 105 in Figure 3.

. It should be noted that the term "comprising" does not exclude other elements or steps and the "a" or "an" does not exclude a plurality. Also, elements described in association with different embodiments may be combined.

. It should also be noted that reference signs in the claims shall not be construed as limiting the scope of the claims.

. Implementation of the invention is not limited to the preferred embodiments shown in the figures and described above. Instead, a multiplicity of variants is possible which use the solutions shown and the principle according to the invention even in the case of fundamentally different embodiments.

### List of reference signs:

| | | | |
|---|---|---|---|
| 100 | component carrier | 700 | conventional component carrier |
| 101 | stack | 701 | stack |
| 102 | electrically conductive layer structure | 702 | electrically conductive layer structure |
| 103 | outermost electrically insulating layer structure | 703 | outermost electrically insulating layer structure |
| 104 | further electrically insulating layer structure | 704 | further electrically insulating layer structure |
| 105 | opening | 705 | conventional opening |
| 106 | conductive portion | 706 | conductive portion |
| 107 | lateral wall | 707 | lateral wall |
| 108 | symmetry axis | 711 | conventional laser beam |
| 109 | main surface | | |
| 110 | electrically conductive connection material | | |
| 111 | laser beam | | |
| 112 | scattering device | | |
| 113 | mirror | | |
| 114 | opening area | | |
| 115 | surrounding area | | |
| 201 | section | | |
| 202 | further section | | |
| 203 | further opening | | |
| 401 | transition portion | | |
| 402 | external main surface | | |
| D1 | inner diameter | | |
| D2 | outer diameter | | |
| w1, w2 | diameter differences | | |

## Claims

1. Component carrier (100), comprising
a stack (101) comprising at least one electrically conductive layer structure (102) and a plurality of electrically insulating layer structures,
wherein an outermost electrically insulating layer structure (103) of the plurality of electrically insulating layer structures comprises sections (201, 202) with a plurality of openings (105), said sections (201, 202) corresponding to several planar positions at said outermost electrically insulating layer structure (103),
wherein each opening (105) exposes a conductive portion (106) associated to the least one electrically conductive layer structure (102),
wherein each opening (105) has a lateral wall (107) defining the circumference of the respective opening (105),
wherein the circumference of each opening (105) has a symmetry axis (108) being perpendicular to a main surface (109) of the electrically conductive layer structure (102).

2. Component carrier (100) according to claim 1,
wherein the lateral walls (107) of the openings (105) have the same shape and the same extension with respect to each other.

3. Component carrier (100) according to claim 1 or 2,
wherein the lateral wall (107) of at least one of the openings (105) comprises a homogeneous shape and extension.

4. Component carrier (100) according to one of the claims 1 to 3,
wherein the lateral walls (107) of at least one opening (105) form a cylindrical shape of the opening (105).

5. Component carrier (100) according to one of claims 1 to 4,
wherein the lateral wall (107) of at least one opening (105) is substantially perpendicular with respect to the main surface (109) of the electrically conductive layer structure (102) and/or parallel to the symmetry axis (108) of the opening (105).

6. Component carrier (100) according to claim 4 or 5,
wherein the symmetry axis (108) of the at least one opening (105) forming the cylindrical shape has an inclination tolerance with respect to the main surface (109) of the electrically conductive layer structure (102) between 10 to 20 degrees.

7. Component carrier (100) according to one of the claims 1 to 6,
wherein the lateral walls (107) of the openings (105) merges with the external main surface of the outermost electrically insulating layer structure (103) by a respective transition portion,
wherein the transition portions of the plurality of openings (105) have in particular the same shape, the same extension and/or the same dimension one to each other, and/or,
wherein the transition portions comprise a rounded edge, and/or,
wherein the transition portions have a different shape with respect to the lateral wall (107) of the respective openings (105), and/or
wherein the transition portions extend through the outermost electrically insulating layer structure (103) of less than one half of the thickness of the outermost electrically insulating layer structure (103).

8. Component carrier (100) according to one of the claims 1 to 7,
wherein the plurality of openings (105) have substantially the same planar extension, in particular same diameters, with respect to each other,
wherein the in particular planar extension differences, in particular the diameter differences of the diameters of the openings (105) in the section (201), are less than 0,1%.

9. Component carrier (100) according to one of the claims 1 to 8,
wherein the sections comprise a section (201) and a further section (202), each one with a plurality of openings (105) and further openings (203) exposing a conductive portion (106) associated to the least one electrically conductive layer structure (102),
in particular, wherein the openings (105) and the further openings (203) have different dimensions, in particular different diameters, with respect to each other,
wherein the shape and the extension of the lateral walls (107) of the respective openings (105) and the further openings (203) are in particular the same.

10. Component carrier (100) according to one of the claims 1 to 9,
wherein each of the openings (105, 203) of at least one of the sections (201, 202) is filled by an electrically conductive connection material (110) for forming in particular an electrically conductive protrusion, in particular a solder material-ball,
wherein the volumes of the electrically conductive connection materials (110) protruding out of the respective openings (105, 203) are in particular equal to each other.

11. Component carrier (100) according to one of the claims 1 to 10,
wherein the outermost electrically insulating layer structure (103) is a solder resist layer,
wherein the solder resist layer is in particular a solder resist ink or a dry film layer.

12. Method of manufacturing a component carrier (100), the method comprising
providing a stack (101) comprising at least one electrically conductive layer structure (102) and a plurality of electrically insulating layer structures,
forming in sections (201, 202) of an outermost electrically insulating layer structure (103) of the plurality of electrically insulating layer structures a plurality of openings (105), said sections (201, 202) corresponding to several planar positions at said outermost electrically insulating layer structure (103) wherein each opening (105) exposes a conductive portion (106) associated to the least one electrically conductive layer structure (102),
wherein each opening (105) has a lateral wall (107) defining the circumference of the respective opening (105),
wherein the circumference of each opening (105) has a symmetry axis (108) being perpendicular to a main surface (109) of the electrically conductive layer structure (102).

13. Method according to claim 12,
wherein the step of forming the plurality of openings (105) comprises
radiating at least one laser beam (111) to a surrounding area surrounding an opening area (114), so that the surrounding area (114) is hardened, and
removing material of the outermost electrically insulating layer structure (103), in particular by a wet chemical process, at the opening area (114) for forming the openings (105).

14. Method according to claim 13,
wherein the step of providing at least one laser beam comprises
scattering the laser beam through a scattering device (112),
wherein the scattering device (112) is configured so that the laser beam is split to provide a plurality of scattered laser beams,
wherein each scattered laser beam (111) is formed by being reflected at a point of incidence on a reflecting portion of the scattering device (112),
wherein the points of incidence being provided in the scattering device (112) at different positions with respect to focal points on the outermost electrically insulating layer structure (103),
wherein the scattered laser beams (111) penetrate the different focal points on the outermost electrically insulating layer structure (103) of the stack (101), so that the scattered laser beams (111) harden the surrounding area (114) surrounding the plurality of openings (105) and so that the circumference of each opening (105) has the symmetry axis (108) being perpendicular to a main surface (109) of the electrically conductive layer structure (102).

15. Method according to claim 14,
wherein the scattering device (112) comprises a plurality of mirrors (113) for generating scattered laser beams (111),
wherein each scattered laser beam (111) is reflected at one of the points of incidence on said mirrors (113).
